(19) **Europäisches Patentamt**

**European Patent Office**

**Office européen des brevets**

(11) **EP 1 121 760 B1**

(12) **EUROPÄISCHE PATENTSCHRIFT**

(45) Veröffentlichungstag und Bekanntmachung des Hinweises auf die Patenterteilung:
**22.05.2002 Patentblatt 2002/21**

(21) Anmeldenummer: **99953617.0**

(22) Anmeldetag: **27.08.1999**

(51) Int Cl.⁷: **H03M 13/17**

(86) Internationale Anmeldenummer:
**PCT/DE99/02686**

(87) Internationale Veröffentlichungsnummer:
**WO 00/22737 (20.04.2000 Gazette 2000/16)**

(54) **VORRICHTUNG UND VERFAHREN ZUR CODIERUNG UND DECODIERUNG VON DATEN MIT EINEM FIRE CODE**

DEVICE AND METHOD FOR CODING DATA WITH A FIRE CODE

DISPOSITIF ET PROCEDE POUR CODER DES DONNEES AVEC UN FIRE CODE

(84) Benannte Vertragsstaaten:
**AT DE FR GB IT**

(30) Priorität: **13.10.1998 DE 19846723**

(43) Veröffentlichungstag der Anmeldung:
**08.08.2001 Patentblatt 2001/32**

(73) Patentinhaber: **ROBERT BOSCH GMBH**
**70442 Stuttgart (DE)**

(72) Erfinder:
• **LAUMEN, Josef**
**D-31141 Hildesheim (DE)**
• **ADI, Wael**
**D-38106 Braunschweig (DE)**

(56) Entgegenhaltungen:
**US-A- 5 381 423**

• **AURER B: "A MODIFIED DECODING ALGORITHM FOR THE FIRE CODE WITH FAST BURST ERROR CORRECTING" ITI 1994, PROCEEDINGS OF THE 16TH INTERNATIONAL CONVERENCE ON INFORMATION TECHNOLOGY INTERFACES, UNIVERSITY OF ZAGREB, COMPUT. CENTER, 14. - 17. Juni 1994, Seiten 355-360, XP002127690 PULA (CROATIA)**

## Beschreibung

### Stand der Technik

Die Erfindung geht aus von einer Vorrichtung bzw. einem Verfahren zur Codierung und Decodierung von Daten nach der Gattung der unabhängigen Patentansprüche. Aus der DE 30 32 468 sind bereits Codierungsverfahren- und vorrichtungen bekannt, die einen sogenannten Fire-Code nutzen. Für einen derartigen Code wird ein Generatorpolynom in der Form $G(x) = P(x)(1 + x^c)$ verwendet wobei $P(x)$ ein sogenanntes irreduzibles Polynom vom Grade m ist. Die Verwendung eines derartigen Fire-Codes erlaubt bei der Decodierung eine einfache Erkennung bzw. Korrektur von Fehlern.

Darüber hinaus wird in der Veröffentlichung "A MODIFIED DECODING ALGORITHM FOR THE FIRE CODE WITH FAST BURST ERROR CORRECTING", B. Aurer, ITI 1994, Proceedings of the 16th. international conference on information technology interfaces, Pula (Croatia), university of Zagreb, Comput. center, 14.-17. Juni 1994, Seiten 355-360 (XP2127690), ein Verfahren zur Decodierung von verkürzten Fire Codes mit automatischer Anpassung an variable Blocklängen offenbart.

### Vorteile der Erfindung

Durch das erfindungsgemäße Verfahren bzw. Vorrichtung zur Codierung und Decodierung kann auf einfache Weise die Redundanz des Codes verändert werden. Ein derartiger variabler Redundanz Code (VRC) kann besonders einfach zur Anpassung von Datenraten benutzt werden.

Weitere Vorteile und Weiterbildungen der Erfindung ergeben sich aus den abhängigen Patentansprüchen. Besonders vorteilhaft ist bei der Decodierung wahlweise ein Gewicht auf die Fehlererkennung bzw. Fehlerkorrektur zu legen.

### Zeichnungen

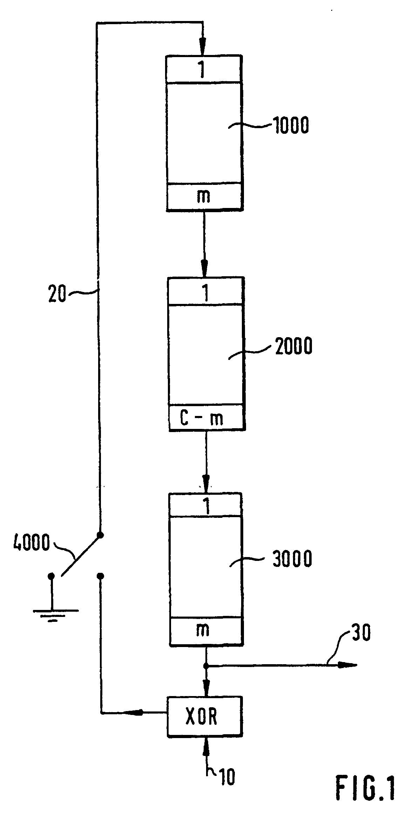

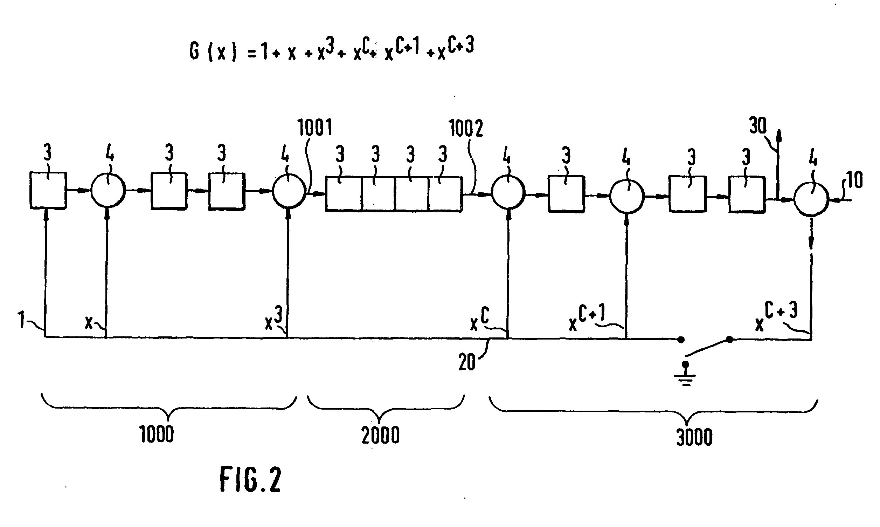

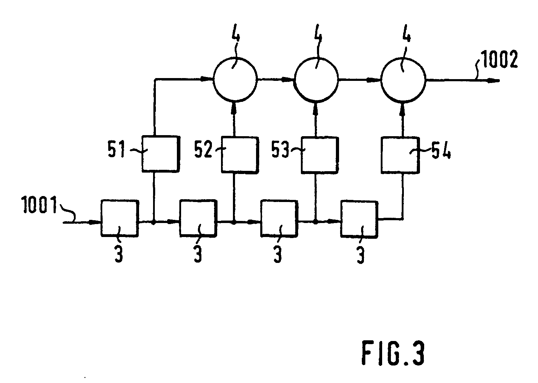

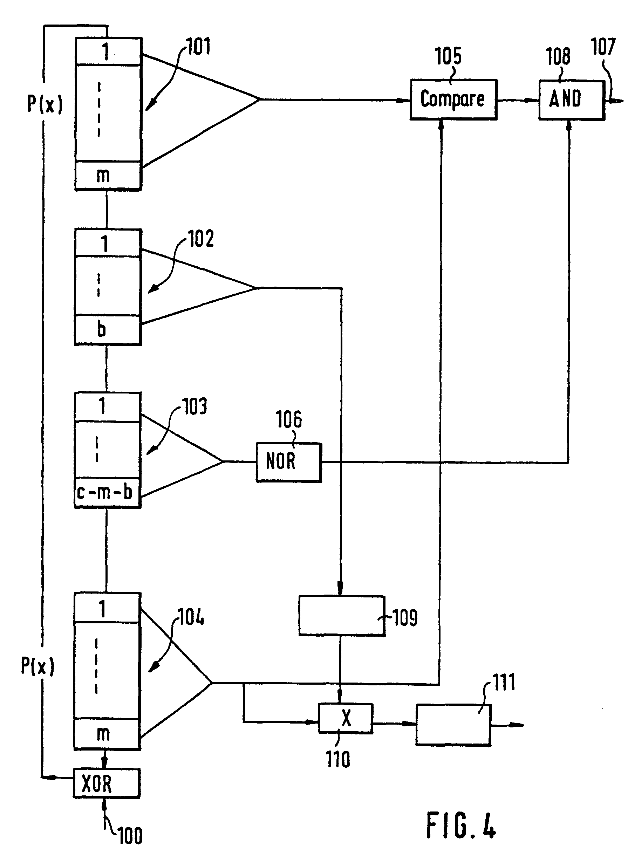

Die Erfindung wird in den Zeichnungen dargestellt und in der nachfolgenden Beschreibung näher erläutert. Es zeigen Figur 1 ein allgemeines Blockschaltbild einer Codiervorrichtung nach dem Fire-Code, Figur 2 eine Codiereinrichtung am Beispiel des Polynoms $P(x) = 1 + x + x^3$, Figur 3 einer Teilvorrichtung aus Figur 1 und 2 zur Erzeugung variabler Redundanz und Figur 4 eine Decodierungsvorrichtung.

### Beschreibung

In der Figur 1 wird die erfindungsgemäße Codierungsvorrichtung schematisch dargestellt. Die Gesamtvorrichtung nach der Figur 1 ist zur Codierung nach einem Fire-Code ausgebildet. Der Codierer weist einen ersten Teilcodierer 1000 auf, der die Daten 20 erhält und mittels eines irreduziblen Polynoms $P(x)$ codiert. Die Daten 20 wurden mittels einer Modulo 2 Verknüpfung des Eingangs 10 mit dem Ausgang des Teilcodierers 3000 erzeugt.

Der Codierer weist einen zweiten Teilcodierer 3000 auf, der ebenfalls die Daten 20 erhält und gemäß $x^c \cdot P(x)$ codiert. Zwischen diesen beiden Teilcodierern befindet sich eine Vorrichtung 2000 zur Erzeugung variabler Redundanz. Die so codierten Daten werden dann am Ausgang 30 ausgelesen. Während der ersten k Takte, d.h. in der Zeit, in der die k Eingangsbits von 10 gelesen werden, befindet sich der Schalter 4000 in der gezeichneten, geschlossenen Position. Zum anschließenden Auslesen der Redundanz (r Bits) am Ausgang 30, wird der Schalter 4000 für die Dauer von r Takten geöffnet.

Durch die beiden Teilcodierer 1000 und 3000, sowie die Vorrichtung 2000 wird somit ein Generatorpolynom $G(x) P(x)(1 + x^c)$ der Codierung realisiert.

In der Figur 2 wird ein Beispiel für den Codierer nach Figur 1 dargestellt. Exemplarisch sei hier ein Polynom $P(x) = 1 + x + x^3$ realisiert. Polynome haben generell die Form $P(x) = 1 + a_1 x + a_2 x^2 + ... + a_m x^m$ wobei a den Wert 0 oder 1 annehmen kann. Beim vorliegenden Beispiel $P(x) = = 1 x + x^3$ besteht der Teilcodierer 1000 aus drei Speicherelemente eines Schieberegisters, die nacheinander angeordnet sind. Die am Eingang 10 anliegenden Bits werden zunächst mit dem Ausgang des Teilcodierers 3000 Modulo 2 verknüpft. Die so erhaltenen Daten 20 werden nacheinander durch die Speicherelemente 3 hindurch geschoben. Nach dem ersten Speicherelement 3 und dem dritten Speicherelement 3 sind jeweils Modulo-2-Addierer 4 vorgesehen, die als XOR-Glieder ausgebildet sind. Beide Modulo-2-Addierer 4 werden ebenfalls mit den Daten 20 beaufschlagt.Der Ausgang 1001 dieses Teilcodierers ist mit dem Eingang der nachfolgenden Teilvorrichtung 2000 verbunden, welche in Figur 3 detaillierter gezeichnet wird. Der Ausgang 1002 der Teilvorrichtung 2000 ist mit dem folgenden Teilcodierer 3000 verbunden, welcher analog zu Teilcodierer 1000 ausgeführt ist.

In der Figur 3 wird die Teilvorrichtung 2000 zur Erzeugung variabler Redundanz dargestellt. In der Figur 3 wird ein Schieberegister bestehend aus vier (allgemein c-m, wie in Figur 1 gezeigt) nacheinander angeordneten Speicherelementen 3 gezeigt. Nach jedem dieser Speicherelemente ist ein Abgriff vorgesehen, der über Schalter 51, 52, 53, 54 mit Eingängen von Modulo-2-Addierern 4 verbunden ist. Beide Eingänge dieser Modulo-2-Addierer 4 sind mit zwei der Schalter 51, 52, 53 und 54 verbunden. Der Ausgang des letzten Modulo-2-Addierers 4 ist mit dem Eingang 1002 der zweiten Teilcodiereinrichtung 3000 verbunden. Durch die Schalter 51, 52, 53, 54 kann nun wahlweise eine Verbindung der Abgriffspunkte zwischen den einzelnen Speicherplätzen des Schieberegisters unter den Modulo-2-Addierern 4 hergestellt werden. Es können nun durch Schließen der Schalter 51, 52, 53 oder 54 unterschiedliche Generatorpolynome des Gesamtcodierers nach Figur 1 und 2 realisiert werden. Da hier ein Polynom in der Form $1 + x^c P(x)$ realisiert werden soll, wird jeweils nur einer der Schalter 51, 52, 53, 54 geschlossen (d.h. es wird die Verbindung hergestellt), während alle anderen Schalter geöffnet sind (d.h. die Verbindung ist unterbrochen). Durch Schließen des Schalters 51 in Verbindung mit dem in Figur 2 gewählten irreduziblen Polynom wird z.B. ein Generatorpolynom des Kodierers der Form $(1 + x^4) \cdot (1 + x + x^3)$ realisiert, durch Schalten des Schalters 52 ein Polynom der Form $(1 + x^5) \cdot (1 + x + x^3)$, durch Schalter 53 $(1 + x^6) \cdot (1 + x + x^3)$ und durch Schalter 54 $(1 + x^7) \cdot (1 + x + x^3)$. Die gezeigte Vorrichtung ist damit in der Lage in Abhängigkeit von der Stellung der Schalter 51, 52, 53, 54 unterschiedlich viel Redundanz zur Gesamtcodierung beizutragen.

Die in den Figuren 1 bis 3 gezeigte Vorrichtung ist somit in der Lage, bei der Codierung von Daten unterschiedlich viel Redundanz zu verwenden. Durch Stellung der Schalter können variabel zwischen einem bis vier Bit zusätzliche Redundanz realisiert werden. Ein derartiger Coder kann somit verwendet werden, um variabel die Redundanz festzulegen, so daß im folgenden auch von einem VRC (variabler Redundanz Coder) gesprochen wird. Derartige VRC können vorteilhaft zur Anpassung von Redundanz an einen Datenkanal verwendet werden. Dies ist vor allen Dingen dann von Interesse, wenn für den Übertragungskanal nur fest vorgegebene Werte für die Datenrate möglich sind, aber die Datenrate der Quelldaten variiert. Es kann dann in besonders einfacher Weise durch Hinzufügen von zusätzlichen Redundanzbits die Übertragungssicherheit erhöht werden.

Das Verfahren und die Vorrichtung zur Codierung mit variabler Redundanz wie es in den Figuren 1 bis 3 beschrieben wurde, eignet sich besonders zusammen mit einer Decodierungsvorrichtung bzw. der Decodierungsmethode nach der DE 30 32 468 verwendet wird. In der Figur 4 wird daher noch einmal als Übersichtsschaubild der Decoder nach der Figur 1 der De 30 32 468 gezeigt. Die Daten werden auf einen Eingang 100 gegeben um dann in mehreren aufeinanderfolgenden Registern 101, 102, 103, 104 ausgewertet zu werden. Bei den Registern 101 und 104 handelt es sich um übliche Decodierungsvorrichtungen die zur Decodierung nach dem Polynom $P(x)$ ausgebildet sind. Das Schieberegister 102 weist b Speicherplätze und das Schieberegister 103 C-m-b Speicherplätze auf. Bei C handelt es sich um die Potenz des Polynoms $1 + x^c$ und m ist der Grad des Polynoms $P(x)$. Praktische Relevanz für korrigierende Codes haben lediglich Werte von c, die größer sind, als der Wert von m. Bei der Zahl b handelt es sich um eine wählbare Größe durch die vorgegeben wird, wieviel Fehler korrigierbar sein sollen. Die Zahl b ist auf jeden Fall geringer als das Minimum der Zahlen m und (c+1)/2. Die Register 102 und 103 sind nun derartig ausgebildet, daß durch Schalter, wie dies bereits zur Figur 3 beschrieben wurde, Schieberegister variabler Länge erzeugt werden. Es kann somit in Abhängigkeit von den vorgegebenen Parametern, die Länge des Registers 102 und die Länge des Registers 103 frei eingestellt werden. Durch diese Maßnahme kann somit die Decodierung der codierten Daten variabel gehandhabt werden. In Abhängigkeit davon welcher Wert für C bei der Codierung gewählt wurde, wird der Wert von C eingestellt. Weiterhin hat der Benutzer noch die Freiheit zu entscheiden, ob es ihm wichtiger ist Datenfehler zu korrigieren oder Datenfehler zu erkennen. In Abhängigkeit davon wird er die Größen b und d auswählen.

Wie bereits in DE 30 32 468 beschrieben wurde, werden die Daten so lange am Eingang 100 angelegt, bis in den Registern 101 und 104 das gleiche Bitmuster auftritt. Dies wird durch den Vergleicher 105 festgestellt. Wenn außerdem im dritten Register 103 nur Nullen enthalten sind, dann tritt im zweiten Register 102 das gesuchte Fehlermuster auf. Die Bedingung, daß alle Registerplätze im Register 103 eine Null aufweisen wird durch das NOR-Glied 106 festgestellt und es wird nur dann ein "Error-Trapped"-Signal am Ausgang 107 ausgegeben, wenn das UND-Glied 108 sowohl ein Signal vom NOR-Glied 106 und vom Vergleicher 105 erhält. Wie bereits in der DE 30 32 468 beschrieben wurde, wird das dann im Register 102 enthaltene Fehlermuster über die Codierstufe 109 in einen Vektor mit m-Bits transformiert und in der Multiplizierstufe 110 mit den entsprechenden Werten des Registers 104 multipliziert. Durch die Logikschaltung 111 kann das Ergebnis der Multiplizierstufe 110 dann, wie bereits in der DE 30 32 468 beschrieben wurde, dazu verwendet werden festzustellen, welche Bits fehlerhaft sind.

Ein Beispiel: Als VRC-Code wird ein Fire-Code eingesetzt, der die Fähigkeit besitzt, Bündelfehler zu korrigieren. Sei dieser Fire-Code nach der DE 30 32 468 definiert als $G(x) = (1 + x^c) \cdot P(x)$, mit e, $e \leq 2^m - 1$, der Periode des irreduziblen Polynoms $P(x)$ vom Grad m. Die Periode des Polynoms $P(x)$ bestimmt in Verbindung mit c die Länge des gewählten Codes, d.h. die Länge eines VRC-kodierten Datenpackets ist auf maximal $n = k + r = KGV\{e,c\}$ beschränkt, wobei $KGV\{a,b\}$ das kleinste gemeinsame Vielfache von a un b bezeichnet.

Die Höhe der durch diesen Fire-Code eingefügten Redundanz sei $r = c + m$ [Bits]. Der Wert c sollte dann der Bedingung $c \geq 2 \cdot b - 1$ genügen, wobei b die Länge eines Bündelfehlers darstellt, der noch mit Hilfe dieses Codes korrigiert werden kann und maximal den Wert m annehmen kann (d.h. $b \leq m$). Wird dieser Blockcode anschließend noch mit Hilfe eines Interleavers über v Datenrahmen verteilt, so wird seine Korrekturfähigkeit um den Faktor v verbessert auf $b' = b \cdot v$, d.h. tritt in den v Datenrahmen ein einziger Burstfehler mit maximalen Länge $b' = b \cdot v$ auf, so werden diese v Datenrahmen korrekt rekonstruiert.

Um stets eine sinnvolle, maximale Fehlererkennung zu gewährleisten, aber ein Kompromiß zwischen Fehlererkennung und Fehlerkorrektur eingegangen werden muß, werden typischerweise kleine Werte für b gewählt. Denn mit d, der Länge eines erkennbaren Fehlerbündels eines Datenrahmens, und b, der Länge korrigierbarer Bündelfehler, gilt: d = c + 1 - b. D.h. tritt bei der Übertragung eines Datenrahmens ein einziger Bündelfehler in diesem Rahmen auf, so kann der Decoder diesen Bündelfehler vollständig korrigieren, solange die Länge des Bündelfehlers den Wert von b [Bits] nicht überschreitet. Übersteigt die Länge des Bündelfehlers den Wert von b, so kann er zwar nicht mehr korrigiert werden, die Dekodiereinrichtung erkennt diesen Bündelfehler allerdings noch - unter der Voraussetzung, daß der Burst nicht länger ist als der Wert von d. Tritt jedoch ein Bündelfehler mit einer Länge größer als d auf, so kann es passieren, daß der Dekoder diesen Fehler nicht mehr erkennt und eventuell falsch korrigiert. D.h. der Dekoder "glaubt", den Datenrahmen korrekt rekonstruiert zu haben, obwohl er immer noch fehlerhaft ist.

Auch die Fähigkeit des Dekoders, Bündelfehler zu erkennen, wird durch einen über v Datenrahmen wirkenden Interleaver um den Faktor v verbessert auf d' = d . v, d.h. tritt in den v Datenrahmen ein einziger, zusammenhängender Burstfehler mit maximaler Länge d' = d . v auf, so werden dieser Burstfehler vom Code noch erkannt.

Figur 4 stellt ein Beispiel für eine Implementierung eines VRC-Codes mittels Fire-Code dar. Zuerst wird das irreduzible Polynom P(x) ausgewählt. Hier sei folgendes Polynom der Länge m = 16 [Bits] gewählt:
$P(x) = 1100000100000011 = 1 + x + x^8 + x^{15} + x^{16}$, mit m = 16, Periode e = 257 = $2^8$ + 1.

Daraus folgt eine maximale Codelänge von KGV{e,c} = 257 . c [Bits], in Abhängigkeit von der Einstellung für c. Der Wert für c ergibt sich unmittelbar aus der bekannten Blocklänge k des zu kodierenden Datenstroms und der ebenfalls vorgegebenen Blocklänge n der VRC-kodierten Daten auf dem physikalischen Kanal. Mit n = k + r, der Redundanz r = c + m und dem festen Wert m = 16 ergibt sich c = r - m = n - k - m..

Die Eigenschaften der (Bündel-)Fehlerkorrektur und der (Bündel-)Fehlererkennung können nun gegeneinander abgeglichen werden. Fehlerkorrektur kann zwischen b = 0 und b = min { m, (c + 1) / 2 } gewählt werden, wobei die Wahl von b wegen d = c + 1 - b direkten Einfluß auf die Erkennungsfähigkeiten des VRC-Codes hat. Ein Kompromiß ist nötig.

Beispiel: Vorgegeben seien die Werte k = 280, die Länge eines Quelldatenrahmens, n = 320, die geforderte Anzahl Bits pro Datenrahmen nach der VRC-Kodierung und m = 16 mit P(x) wie oben.
Die zuzufügende Redundanz ergibt sich somit zu r = n - k = 320 - 280 = 40. Mit m = 16 wird nun c zu c = 24. Die Korrekturfähigkeit des Codes soll sich auf b = 3 [Bits] beschränken, um so eine relativ hohe Fehlererkennung von d = c + 1 - b = 24 + 1 - 3 = 22 [Bits] zu gewährleisten. Das bedeutet, daß ein Bündelfehler bis zu einer Länge von 22 Bits vom Decoder nicht falsch korrigiert wird, sondern als Fehler erkannt wird. Entweder wird der Dekodiervorgang in einem solchen Fall mit einer Fehlermeldung abgebrochen oder aber der dekodierte Bitstrom wird als fehlerhaft markiert. Tritt jedoch ein Bündelfehler von lediglich 3 Bit Länge in einem Datenrahmen der Länge n = 320 auf, so kann dieser vollständig korrigiert werden; der Quellbitstrom wird fehlerfrei rekonstruiert.

Die Implementierung dieses flexiblen Codes, dessen Eigenschaften dynamisch den äußeren Voraussetzungen angepaßt werden kann, erfordert keine besonderen Veränderungsmaßnahmen an der Architektur des Decoder nach der Figur 4 bzw. der DE 30 32 468. Die Veränderung der beiden Parameter c und b bewirkt lediglich, daß die Register 102 und 103 des Decoders mit variabler (logischer) Länge ausgelegt werden müssen. Zusätzlich bestimmen die Extremwerte von c und b die Breite der in Figur 4 gezeigten NOR-Gatter 106 und der Codierstufe 109.

Im o.a. Beispiel wurde ein Code mit c = 14 betrachtet. Das bedeutet, daß die unverkürzte Codelänge, d.h. die maximal zulässige Anzahl Bits n in einem gültigen Codewort nmax = ( k + r )max = e . c = KGV{257,24} = 6168[Bits] beträgt. Der Code wurde allerdings als verkürzter Code mit n = 320 realisiert. Verkürzte Codes i. a. und stark verkürzte Codes im besonderen, haben die Eigenschaft, daß ihre Fehlerschutzcharakteristik d' > d und b' > b teilweise erheblich besser ist, als die Eigenschaften (d und b) des unverkürzten Muttercodes. Eine quantitative Aussage über diese Verbesserung ist jedoch lediglich experimentell ermittelbar.

**Patentansprüche**

1. Vorrichtung zur Codierung von Daten nach einem Fire-Code G (x) = P (x) (1 + $x^c$), wobei P (x) ein irreduzibles Polynom vom Grade m ist, **dadurch gekennzeichnet, daß** der Wert für C in vorgegebenen Grenzen frei einstellbar ist.

2. Vorrichtung nach Anspruch 1, **dadurch gekennzeichnet, daß** die obere Grenze für C durch einen Maximalwert vorgegeben wird, und daß die Codierungseinrichtung Speicherelemente (3) und Modulo-2-Addierer (4) aufweist, deren Zahl der Maximalzahl entspricht, und daß Schalter (51, 52,... 53, 54) vorgesehen sind, durch die die Speicherplätze (3) und Modulo-2-Addierer (4) zu einem Coder entsprechend dem gewählten Wert für C zusammenschaltbar sind.

3. Decoder zur Decodierung von Daten nach einem Fire-Code G (x) = P (x) (1 + $x^c$), wobei P (x) ein irreduzibles Polynom vom Grade m ist, **dadurch gekennzeichnet, daß** der Wert für C in vorgegebenen Grenzen frei einstellbar ist.

4. Decoder nach Anspruch 3, **dadurch gekennzeichnet, daß** ein Schieberegister (103) vorgesehen ist, wobei die Länge des Schieberegisters (103) in Abhängigkeit vom Wert für C einstellbar ist.

5. Decoder nach Anspruch 4, **dadurch gekennzeichnet, daß** ein zweites Schieberegister (102) vorgesehen ist, dessen Länge auf einen Wert B einstellbar ist, wobei B auf jeden Fall kleiner als M ist, und wobei durch B die maximale Anzahl der korrigierbaren Bitfehler angegeben wird.

6. Verfahren zur Codierung von Daten nach einem Fire-Code $G(x) = P(x)(1 + x^c)$, wobei $P(x)$ ein irreduzibles Polynom vom Grade m ist, **dadurch gekennzeichnet, daß** der Wert für C in vorgegebenen Grenzen frei einstellbar ist.

7. Verfahren zur Decodierung von Daten nach einem Fire-Code $G(x) = P(x)(1 + x^c)$, wobei $P(x)$ ein irreduzibles Polynom vom Grade m ist, **dadurch gekennzeichnet, daß** der Wert für C in vorgegebenen Grenzen frei einstellbar ist.

8. Verfahren nach 7 **dadurch gekennzeichnet, daß** die Werte b und d -Länge eines korrigierbaren bzw. erkennbaren Fehlerbündels- für die Fehlerkorrektur- und Erkennungseigenschaften der eingefügten Redundanz in vorgegebenen Grenzen und gemäß $d = c + 1 - b$ frei einstellbar sind.

9. Verfahren nach 8 **dadurch gekennzeichnet, daß** die Werte b und d für die Fehlerkorrektur- und Erkennungseigenschaften der eingefügten Redundanz an die jeweilige Qualität des Übertragungskanals (z.B. Bitfehlerrate) angepaßt werden.

**Claims**

1. Device for coding data using a fire code $G(x) = P(x)(1 + x^c)$, $P(x)$ being an irreducible polynomial of degree m, **characterized in that** the value for C can be freely set within prescribed bounds.

2. Device according to Claim 1, **characterized in that** the upper bound for C is prescribed by a maximum value, and **in that** the coding device has memory elements (3) and module-2-adders (4) whose number corresponds to the maximum number, and **in that** switches (51, 52,... 53, 54) are provided by means of which the memory locations (3) and module-2-adders (4) can be interconnected to form a code in accordance with the selected value for C.

3. Decoder for decoding data using a fire code $G(x) = P(x)(1 + x^c)$, $P(x)$ being an irreducible polynomial of degree m, **characterized in that** the value for C can be freely set within prescribed bounds.

4. Decoder according to Claim 3, **characterized in that** a shift register (103) is provided, it being possible to set the length of the shift register (103) as a function of the value for C.

5. Decoder according to Claim 4, **characterized in that** a second shift register (102) is provided, whose length can be set to a value B, B being smaller than M in any event, and B specifying the maximum number of correctable bit errors.

6. Method for coding data using a fire code $G(x) = P(x)(1 + x^c)$, $P(x)$ being an irreducible polynomial of degree m, **characterized in that** the value for C can be freely set within prescribed bounds.

7. Method for decoding data using a fire code $G(x) = P(x)(1 + x^c)$, $P(x)$ being an irreducible polynomial of degree m, **characterized in that** the value for C can be freely set within prescribed bounds.

8. Method according to Claim 7, **characterized in that** the values b and d - length of a correctable and/or detectible error burst - for the error-correction and detection properties of the introduced redundancy can be freely set within prescribed bounds and in accordance with $d = c + 1 - b$.

9. Method according to Claim 8, **characterized in that** the values b and d - length of a correctable and/or detectible error burst - for the error-correction and detection properties of the introduced redundancy can be matched to the respective quality of the transmission channel (for example bit error rate).

**Revendications**

1. Dispositif de codage de données selon un code Fire

$$G(x) = P(x)(1 + x^c)$$

dans lequel $P(x)$ est un polynôme irréductible de degré (m),
**caractérisé en ce que**
la valeur de C est réglable librement dans des limites prédéterminées.

2. Dispositif selon la revendication 1,
**caractérisé en ce que**
la limite supérieure de C est prédéfinie par une valeur maximale et l'installation de codage comporte des éléments de mémoire (3) et des additionneurs (4) Modulo-2, dont le nombre correspond au nombre maximum et
des commutateurs (51, 52,...53, 54) sont prévus pour combiner les emplacements de mémoire (3) et les additionneurs (4) Modulo-2, pour former un codeur selon la valeur choisie pour C.

3. Décodeur pour décoder les données selon un code Fire

$$G(x) = P(x)(1 + x^c),$$

relation dans laquelle P (x) est un polynôme irréductible de degré (m),
**caractérisé en ce que**
la valeur de C est réglable librement dans des limites prédéterminées.

4. Décodeur selon la revendication 3,
**caractérisé par**
un registre à décalage (103) dont la longueur est réglée en fonction de la valeur C.

5. Décodeur selon la revendication 4,
**caractérisé en ce qu'**
il comporte un second registre à décalage (102) dont la longueur se règle sur une valeur (b) qui est dans tous les cas inférieure à (m) et (b) étant le nombre maximum d'erreurs de bits que l'on peut corriger.

6. Procédé de codage de données selon un code Fire

$$G(x) = P(x)(1 + x^c)$$

relation dans laquelle P (x) est un polynôme irréductible de degré m,
**caractérisé en ce que**
la valeur de C est réglable librement dans des limites prédéterminées.

7. Procédé de décodage de données selon un code Fire

$$G(x) = P(x)(1 + x^c)$$

relation dans laquelle P (x) est un polynôme irréductible de degré (m),
**caractérisé en ce que**
la valeur de C est réglable librement dans des limites prédéterminées.

8. Procédé selon la revendication 7,
**caractérisé en ce que**
les valeurs (b) et (d) (longueur d'un groupe d'erreurs que l'on peut corriger ou respectivement déceler) pour les propriétés de correction et de détection d'erreurs de la redondance introduite, se règlent librement dans des limites prédéterminées et selon la relation d = c + 1 - b.

9. Procédé selon la revendication 8,
**caractérisé en ce que**
les valeurs (b) et (d) pour les propriétés de correction et de détection d'erreurs selon la redondance introduite sont adaptées à la qualité respective du canal de transmission (par exemple le taux des bits d'erreurs).

FIG.1

$$G(x) = 1 + x + x^3 + x^C + x^{C+1} + x^{C+3}$$

FIG.2

EP 1 121 760 B1

FIG.3

FIG. 4